(19) Europäisches Patentamt
European Patent Office
Office européen des brevets

(11) **EP 2 871 797 A1**

(12) **EUROPÄISCHE PATENTANMELDUNG**

(43) Veröffentlichungstag:
**13.05.2015 Patentblatt 2015/20**

(51) Int Cl.:
*H04L 9/00* (2006.01)     *G01D 4/00* (2006.01)

(21) Anmeldenummer: **14182439.1**

(22) Anmeldetag: **27.08.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **11.11.2013 DE 102013222904**

(71) Anmelder: **Siemens Aktiengesellschaft 80333 München (DE)**

(72) Erfinder: **Bußer, Jens-Uwe 85579 Neubiberg (DE)**

(54) **Zählervorrichtung, Aggregationsvorrichtung und Verfahren zur Ermittlung eines zeitlich kumulierten Verbrauchswertes einer Zählervorrichtung**

(57) Die Ermittlung eines zeitlich kumulierten Verbrauchswertes (V_j) aus Einzelmesswerten (c_ti_j), die von einer Zählervorrichtung (11.j) in einer Anzahl von N aufeinander folgenden Messungen über einen bestimmten Zeitraum (T) gemessen werden, weist als ersten Verfahrensschritt ein Maskieren eines i-ten Einzelmesswerts (c_ti_j), der von der Zählervorrichtung (11.j) zu einem i-ten Zeitpunkt (ti) gemessen wird, durch Addieren mit einem Maskierungswert (s_ti_j) zu einem Übertragungswert (b_ti_j) und das Senden des Übertragungswertes (b_ti_j) zum i-ten Zeitpunkt von der Zählervorrichtung (11.j) zu einer Aggregationsvorrichtung (12) für alle i=1 bis (N-1)-ten Einzelmesswerte (c_ti_j), auf. Darüber hinaus werden in einem weiteren Verfahrensschritt alle N-1 Maskierungswerte (s_ti_j) der Zählervorrichtung (11.j), die für jeden der N-1 Einzelmesswerte (c_ti_j) erzeugt wurden, zu einem Summenmaskierungswert (Ss_tN_j) in der Zählervorrichtung (11.j) addiert. Anschließend wird ein N-ter-Einzelmesswert (c_tN_j), der von der Zählervorrichtung zum N-ten Zeitpunkt gemessen wird, mit dem negativen Summenmarkierungswert (Ss_tN_j) zu einem Übertragungswert (b_tN_j) maskiert und dieser N-te Übertragungsmesswert (b_tN_j) wird von der Zählervorrichtung (11.j) an die Aggregationsvorrichtung (12) gesendet. In der Aggregationsvorrichtung (12) werden alle N empfangenen Übertragungswerte (b_ti_j) der Zählervorrichtung (11.j) zu einem Verbrauchswert (V_j) addiert.

**FIG 1**

EP 2 871 797 A1

**Beschreibung**

Die Erfindung bezieht sich auf eine Zähler- und Aggregationsvorrichtung sowie ein Verfahren zur Ermittlung eines kumulierten Verbrauchswertes einer Zählervorrichtung aus Einzelmesswerten, die von der Zählervorrichtung in einer Anzahl von aufeinander folgenden Messungen über einen bestimmten Zeitraum gemessen werden.

Der zunehmende Einsatz von fluktuierenden regenerativen Energieerzeugern, wie zum Beispiel Windrädern oder Photovoltaik-Anlagen, fordert eine verstärkte Überwachung und Steuerung der Elektrizitätsnetze bis hinab in den Niederspannungsbereich. Als zusätzliche Sensoren sind auch Zähler in Privathaushalten im Gespräch, die mit mehr Intelligenz und Kommunikationsfähigkeit ausgestattet werden sollen, um künftig auch bequeme Fernabfragen der Zählerstände zu erlauben.

Traditionelle elektromechanische Stromzähler zeigen nur die kumulierte Gesamtenergie mittels Rollenzählwerk an, welches manuell, beispielsweise jährlich, abgelesen werden muss. Zur Ermittlung des Verbrauchs muss der im vorigen Jahr abgelesene Wert abgezogen werden. Eine Nutzung dieser Daten ist nur für Abrechnungszwecke, nicht aber zur Energienetzsteuerung möglich.

Moderne elektronische Zähler sind bereits weit verbreitet. Diese senden die gemessenen Verbrauchswerte beispielsweise über eine Stromleitungskommunikation, auch Power Line Communication genannt, oder über eine Mobilfunkverbindung zumeist an einen Datenkonzentrator in der nächstgelegenen Ortsnetzstation. Dort werden dann die Werte vieler intelligenter Zähler gesammelt und beispielsweise über eine Mobilfunkverbindung, eine Standleitung oder einen Lichtwellenleiter an ein zentrales Auswertesystem des Messstellenbetreibers weitergeleitet.

Die Abfrage von Verbrauchsdaten für Abrechnungszwecke, die als Einzelmesswerte von intelligenten Zählern geliefert werden und die über längere Zeit, beispielsweise mehrere Wochen, kumuliert wurden, ist in der Regel datenschutzrechtlich unkritisch. Die Abfrage von Verbrauchsdaten im 15-Minutentakt oder gar im Sekundentakt, wie es für den Einsatz in der Netzsteuerung notwendig wäre, stellt dagegen einen massiven Eingriff in die Privatsphäre der Verbraucher dar, da dadurch die Offenlegung von Verbrauchsgewohnheiten bis hin zur Analyse einzelner Aktivitäten möglich ist.

Um solche Verbrauchsdaten einzelner Zählervorrichtungen in kurzen Abständen von Datenkonzentratoren an Versorgungsunternehmen übermitteln zu können, wird beispielsweise ein Protokoll zur Aggregation von Einzelmesswerten verwendet, das auf der Datenmaskierung mittels gemeinsamer Geheimnisse zwischen verschiedenen Zählervorrichtungen basiert und die Berechnung des Gesamtverbrauchs vieler einzelner Messvorrichtungen zu einer bestimmten Zeit erlaubt, aber einen Rückschluss auf die Einzelmesswerte einzelner Zählervorrichtungen nicht ermöglicht. Ein solches Aggregationsverfahren ist beispielsweise beschrieben als das erste Protokoll in: Klaus Kursawe, George Danezis, and Markulf Kohlweiss, "Privacy-Friendly Aggregation for the Smart-Grid", in: Privacy Enhancing Technologies, 11th International Symposium, PETS 2011, Waterloo, ON, Canada, July 27-29, 2011 Proceedings, S. Fischer-Hübner and N. Hopper (Eds.), Lecture Notes in Computer Science 6794, 2011, Springer Verlag, pp.175-191. Die erfindungsgemäße Modifikation kann in gleicher oder ähnlicher Weise auch auf andere Protokolle mit ähnlicher Datenmaskierung vorteilhaft angewendet werden.

Für Abrechnungszwecke können diese aggregierten Daten daher nicht verwendet werden.

Es ist daher die Aufgabe der vorliegenden Erfindung, ein Aggregationsverfahren zur Ermittlung des Gesamtverbrauchs vieler Zählervorrichtungen, der in kurzen Zeitabständen ermittelt wird, so zu modifizieren, dass auch ein zeitlich kumulierter Verbrauch jeder einzelnen Zählervorrichtung über einen längeren Zeitraum, wie beispielsweise eine Abrechnungsperiode, ermittelt werden kann.

Die Aufgabe wird durch die in den unabhängigen Ansprüchen beschriebenen Maßnahmen gelöst. In den Unteransprüchen sind vorteilhafte Weiterbildungen der Erfindung dargestellt.

Das erfindungsgemäße Verfahren zur Ermittlung eines zeitlich kumulierten Verbrauchswertes aus Einzelmesswerten, die von einer Zählervorrichtung in einer Anzahl von N aufeinander folgenden Messungen über einen bestimmten Zeitraum gemessen werden, weist als ersten Verfahrensschritt ein Maskieren eines $i$-ten Einzelmesswerts, der von der Zählervorrichtung zu einem $i$-ten Zeitpunkt gemessen wird, durch Addieren mit einem Maskierungswert zu einem Übertragungswert und das Senden des Übertragungswertes zum $i$-ten Zeitpunkt von der Zählervorrichtung zu einer Aggregationsvorrichtung für alle $i=1$ bis $(N-1)$-ten Einzelmesswerte, auf. Darüber hinaus werden in einem weiteren Verfahrensschritt alle $N-1$ Markierungswerte der Zählervorrichtung, die für jeden der $N-1$ Einzelmesswerte erzeugt wurden, zu einem Summenmaskierungswert in der Zählervorrichtung addiert. Anschließend wird ein $N$-ter-Einzelmesswert, der von der Zählervorrichtung zum $N$-ten Zeitpunkt gemessen wird, mit dem negativen Summenmarkierungswert zu einem Übertragungswert maskiert und dieser $N$-te Übertragungsmesswert wird von der Zählervorrichtung an die Aggregationsvorrichtung gesendet. In der Aggregationsvorrichtung werden alle $N$ empfangenen Übertragungswerte der Zählervorrichtung zu einem zeitlich kumulierten Verbrauchswert dieser Zählervorrichtung addiert.

Somit kann durch die genannte Bildung eines Summenmaskierungswertes in der Zählervorrichtung und die Verwendung dieses Summenmaskierungswertes als negativen Maskierungswert auf den letzten in dem betrachteten Zeitraum gemessenen Einzelmesswert von der Aggregationsvorrichtung der Verbrauchswert für eine bestimmte Zählervorrichtung bzw. für alle Zählervorrichtungen einfach ermittelt werden. Es ist lediglich eine kleine Erweiterung des bereits verwendeten Aggregationsverfahrens dazu notwendig. Die erfindungsgemäße Modifikation kann in gleicher oder ähnlicher Weise auch auf andere Aggregationsprotokolle mit ähnlicher Datenmaskierung vorteilhaft angewendet werden.

In einer vorteilhaften Ausführungsform bildet die Zählervorrichtung für jede der i=2 bis (N-1)-te Messung einen i-ten Summenmaskierungswert durch Addition des Maskierungswertes der i-ten Messung mit einem Summenmaskierungswert der vorigen (i-1)-ten Messung, wobei der Summenmaskierungswert der ersten Messung dem Maskierungswert der ersten Messung entspricht und die Zählervorrichtung lediglich den i-ten Summenmaskierungswert speichert.

Dadurch reduziert sich der Speicherplatz zur Speicherung der einzelnen Maskierungswerte in der Zählervorrichtung auf lediglich einen einzigen Wert.

In einer weiteren vorteilhaften Ausführungsform bildet die Aggregationsvorrichtung für jede der i=2 bis N-ten Messungen einer Zählervorrichtung einen i-ten Summenübertragungswert durch Addition des Übertragungswertes der i-ten Messung mit einem Summenübertragungswert der vorherigen (i-1)-ten Messung, wobei der Summenübertragungswert der ersten Messung dem Übertragungswert der ersten Messung entspricht. Lediglich der i-te Übertragungswert wird in der Aggregationsvorrichtung gespeichert.

Dies hat den Vorteil, dass in der Aggregationsvorrichtung lediglich ein einzelner Summenübertragungswert gespeichert werden muss, anstatt der Speicherung aller N übermittelten Übertragungswerte aller N Messungen einer Zählervorrichtung. Die Aggregationsvorrichtung kann somit weniger komplex und damit kostengünstiger gehalten werden.

In einem weiteren Ausführungsbeispiel ist der Zeitpunkt zur Ermittlung des Verbrauchswertes fest vorgegeben und somit wird die Anzahl N der Messungen und/oder die Messzeitpunkte so gewählt, dass die N-te Messung jeweils zu der vorgegebenen Zeit durchgeführt wird.

Somit kann automatisch ohne weitere manuelle Eingriffe zu regelmäßigen, fest vorgegebenen Zeitpunkten der Verbrauchswert der einzelnen Zählervorrichtungen ermittelt werden.

In einem weiteren Ausführungsbeispiel wird der Zeitpunkt zur Ermittlung des Verbrauchswertes, beispielsweise durch eine Nachricht, der Zählervorrichtung und der Aggregationsvorrichtung mitgeteilt.

Dadurch kann eine Bestimmung des Verbrauchswertes an einem zusätzlichen bzw. beliebigen Zeitpunkt angefordert werden, beispielsweise um eine Zwischenablesung, insbesondere bei Tarifwechsel, Kundenwechsel oder bei Störung des Verfahrens zur Bestimmung einer beschädigten Zählervorrichtung, anzufordern.

In einer vorteilhaften Ausführungsform werden mehrere verschiedene Teilverbrauchswerte mit mindestens einem unterschiedlichen ersten Zeitpunkt und/oder letzten, N-ten Zeitpunkt ermittelt.

Dies ermöglicht das Führen unterschiedlicher Teilsummen zu verschiedenen Tarifzeiten und ermöglicht somit eine Mehrtarifabrechnung.

In einer weiteren Ausführungsform der vorliegenden Erfindung führt lediglich eine Teilmenge der Zählervorrichtungen jeweils zur gleichen Zeit eine Messung eines Einzelmesswertes durch.

Dadurch können verschiedene Tarifmodelle auf Teilmengen der Zählervorrichtungen angewendet werden und somit jedem Verbraucher bzw. jeder Zählervorrichtung eine individuelle Tarifstruktur angeboten werden.

Die erfindungsgemäße Zählervorrichtung zur Ermittlung eines über einen bestimmten Zeitraum kumulierten Verbrauchswertes umfasst eine Messeinheit, eine Maskiereinheit und eine Kumuliereinheit, wobei die Messeinheit derart ausgebildet ist, um in einer Anzahl von N aufeinander folgenden Messungen eine Anzahl von N Einzelmesswerten zu ermitteln. Die Maskiereinheit ist derart ausgebildet, einen i-ten Einzelmesswert, der zu einem i-ten Zeitpunkt gemessen wird, durch Addieren mit einem Maskierungswert zu einem Übertragungswert zu maskieren und den Übertragungswert zum i-ten Zeitpunkt zu einer Aggregationsvorrichtung zu senden und zwar für alle i=1 bis N-ten Messungen. Die Kumuliereinheit ist derart ausgebildet, alle N-1 Maskierungswerte, die für jeden der (N-1) Einzelmesswerte erzeugt wurden, zu einem Summenmaskierungswert zu addieren, den N-ten Einzelmesswert, der zum N-ten Zeitpunkt gemessen ist, mit dem negativen Summenmaskierungswert zu einem N-ten Übertragungswert zu maskieren und dem N-ten Übertragungswert an die Aggregationsvorrichtung zu senden.

Dies hat den Vorteil, dass das Verfahren zur Aggregation datenschutzrechtlich kritischer, in kurzen Zeitabständen gemessener Einzelmesswerte, also Verbrauchswerte, zu einem über zahlreiche Zählervorrichtungen kumulierten Gesamtmesswert, auch zur Ermittlung von über einen längeren Zeitraum kumulierten Verbrauchswerten der einzelnen Zählervorrichtungen verwendet werden kann. Aus diesen Verbrauchswerten lassen sich keine Aussagen über den zeitlichen Verlauf des Verbrauchs innerhalb des Zeitraums einer jeder einzelnen Zählervorrichtung ableiten. Bei einem kurzen Zeitintervall zwischen Einzelmesswerten für die Netzsteuerung, muss entsprechend die Anzahl N der Einzelmessungen für den gewünschten Abrechnungszeitraum hinreichend groß gewählt werden.

Bei einer weiteren vorteilhaften Ausführungsform ist die Kumuliereinheit derart ausgebildet, dass für jede der i=2 bis (N-1)-ten Messungen ein i-ter Summenmaskierungswert durch Addition des Markierungswertes der i-ten Messung mit dem Summenmaskierungswert der vorherigen (i-1)-ten Messung zu bilden, wobei der Summenmaskierungswert der ersten Messung dem Markierungswert der ersten Messung entspricht und lediglich der i-te Summenmaskierungswert zu speichern ist.

Dies hat den Vorteil, dass eine Zählervorrichtung nicht jeden in der Abrechnungsperiode bereits verwendeten Markierungswert speichern muss, sondern nur die Teilsumme der bereits verwendeten Maskierungswerte speichert.

Die erfindungsgemäße Aggregationsvorrichtung eines kumulierten Verbrauchswerts über einen bestimmten Zeitraum umfasst eine Einzelverbrauchsberechnungseinheit, die derart ausgebildet ist, alle N empfangenen Übertragungswerte einer Zählervorrichtung zu einem Verbrauchswert zu addieren.

Dies hat den Vorteil, dass die Aggregationsvorrichtung ein vorhandenes Aggregationsprotokoll zur datenschutzrechtlich unbedenklichen Erfassung kumulierter Verbrauchswerte innerhalb kurzer Zeitabstände auch zur Ermittlung des Gesamtverbrauchs jeder einzelnen Zählervorrichtung durch lediglich geringe Adaptionen verwenden kann.

In einer vorteilhaften Ausführungsform ist die Einzelverbrauchseinheit derart ausgebildet, dass für jede der i=2 bis N-ten Messungen ein i-ter Summenübertragungswert durch Addition des Übertragungswertes der i-ten Messung mit einem Summenübertragungswert der vorherigen (i-1)-ten Messung gebildet wird, wobei der Summenübertragungswert der ersten Messung dem Übertragungswert der ersten Messung entspricht und lediglich den i-ten Summenübertragungswert zu speichern.

Dies hat den Vorteil, dass die Aggregationsvorrichtung nicht alle empfangenen Übertragungswerte für jede Zählervorrichtung bis zum Ende der Abrechnungsperiode speichern muss, sondern nur die bis dahin berechnete Teilsumme. Somit ist die Erweiterung der Aggregationsvorrichtung auf eine geringe zusätzliche Speicherkapazität beschränkt.

Ausführungsbeispiele der erfindungsgemäßen Zählervorrichtung, Aggregationsvorrichtung sowie des erfindungsgemäßen Verfahrens sind in den Zeichnungen beispielhaft dargestellt und werden anhand der nachfolgenden Beschreibung näher erläutert. Es zeigen:

Figur 1    ein Ausführungsbeispiel eines Aggregationsverfahrens zur Ermittlung datenschutzrechtlich unbedenklicher Verbrauchswerte über eine Anzahl M von Zählervorrichtungen in kurzen Zeitabständen, das um ein Ausführungsbeispiel des erfindungsgemäßen Verfahrens zur Ermittlung kumulierter Verbrauchswerte über einen längeren Zeitraum erweitert ist;

Figur 2    ein Verteilernetz mit erfindungsgemäßen Zählervorrichtungen und einem Ausführungsbeispiel einer erfindungsgemäßen Aggregationsvorrichtung in schematischer Darstellung;

Figur 3    ein Ausführungsbeispiel einer erfindungsgemäßen Zählervorrichtung in Blockdarstellung.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

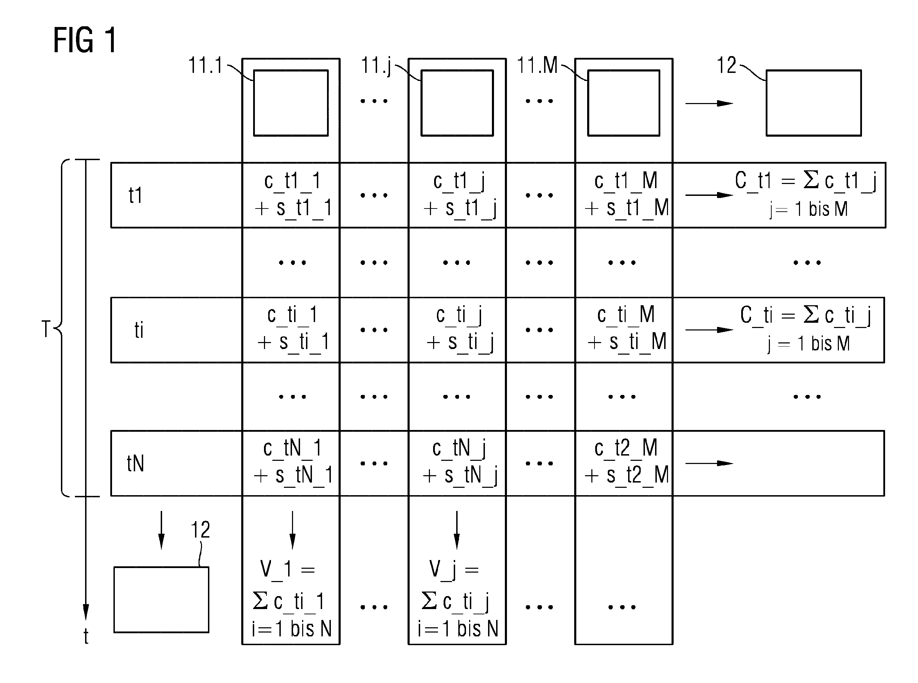

In Figur 1 sind eine Anzahl von M Zählervorrichtungen 11.1,..., 11.M dargestellt, die in einer Anzahl von N aufeinander folgenden Messungen über einen bestimmten Zeitraum T gemessen werden und von jeder Zählervorrichtung 11.1,..., 11.M an eine Aggregationsvorrichtung 12 übermittelt werden.

Zuerst wird nun als Aggregationsprotokoll beispielhaft das in dem oben genannten Artikel von Klaus Kursawe, George Danezis, and Markulf Kohlweiss, "Privacy-Friendly Aggregation for the Smart-Grid" genannte erste Protokoll beschrieben, mit dem zu einem Zeitpunkt ti ermittelte Einzelmesswerte c_ti_1,..., c_ti_M datenschutzrechtlich unbedenklich an die Aggregationsvorrichtung gesendet werden. Dies entspricht einer Zeile in Figur 1. Datenschutzrechtlich unbedenklich heißt dabei, dass in der Aggregationsvorrichtung 12 aus den empfangenen Werten der einzelnen Zählervorrichtungen 11.1,..., 11.M nicht auf den Messwert einer einzelnen Zählervorrichtung 11.1,..., 11.M zurückgeschlossen werden kann.

Dazu wird ein Einzelmesswert c_ti_j der Zählervorrichtung 11.j zum Zeitpunkt ti durch Addition mit einem zufälligen oder pseudozufälligen Maskierungswert s_ti_j zu einem Übertragungswert b_ti_j maskiert. Geht man davon aus, dass alle gemessenen Einzelmesswerte und Übertragungswerte beispielsweise in 32 Bit-Datenfeldern übertragen, verarbeitet und gespeichert werden, so ergibt sich der Übertragungswert zum Messzeitpunkt ti der Zählervorrichtung 11.j zu

$$b\_ti\_j = (c\_ti\_j + s\_ti\_j)\, mod\, 2^{32}$$

Die Maskierungswerte s_ti_i, ..., s_ti_M werden dabei so gewählt, dass sich die Summe der Maskierungswerte zu Null ergibt, d.h.

$$\left( \sum_j s\_ti\_j = 0 \right) mod\, 2^{32}$$

Die genaue Art und Weise, wie die Zählervorrichtungen 11.1,..., 11.M diese Maskierungswerte s_ti_j festlegen, ist nicht von Bedeutung, solange die Maskierungswerte s_ti_j außerhalb der Zählervorrichtung nicht bestimmbar sind und sich die Maskierungswerte aller Zählervorrichtungen in der Summe wegheben. Die Maskierungswerte s_ti_j einer Zählervorrichtung 11.j können dabei beispielsweise von einer übergeordneten Zählervorrichtung oder einer anderen Einheit vorgegeben werden, oder sie werden vorteilhafterweise mit mehreren anderen Zählervorrichtungen ausgehandelt, beispielsweise mit mehreren logisch benachbarten Zählervorrichtungen.

Die Maskierungswerte können auch von mehreren Teilmengen der Zählervorrichtungen jeweils eigenständig ermittelt werden, sodass in jeder Teilmenge die Summe der Maskierungswerte sich ebenfalls zu Null ergibt. Die Teilmengen an Zählervorrichtungen müssen dabei disjunkt sein, also keine gleichen Zählervorrichtungen enthalten.

Jeder der so gebildeten Übertragungswerte b_ti_j,..., b_ti_M wird an die Aggregationsvorrichtung übermittelt und dort werden alle Übertragungswerte b_ti_j,..., b_ti_M aller Zählervorrichtungen 11.1,..., 11.M zum Zeitpunkt ti zu einem Gesamtverbrauchswert C_ti addiert gemäß

$$C\_ti = \sum_j b\_ti\_j = \sum_j (c\_ti\_j + s\_ti\_j) = \left( \sum_j c\_ti_j \right) mod\, 2^{32}$$

Die Berechnung des Verbrauchswertes einer Zählervorrichtung 11.j zu einem Zeitpunkt ti ist durch die Aggregationsvorrichtung 12 nicht möglich, da nur die einzelnen Übertragungswerte b_ti_j bekannt sind, nicht aber der einzelne Messwert c_ti_j und der Maskierungswert s_ti_j. Damit ist es der Aggregationsvorrichtung 12 auch nicht möglich, den Verbrauch V_j einer einzelnen Zählervorrichtung 11.j über einen Abrechnungszeitraum T, der eine Vielzahl von Einzelmessungen zu einer Vielzahl von Zeitpunkten umfassend zu berechnen.

Um nun erfindungsgemäß einen zeitlich kumulierten Verbrauchswert V_j einer Zählervorrichtung 11.j über einen bestimmten Zeitraum T ermitteln zu können, wird nun der Maskierungswert s_tN_j nicht nach den üblichen Verfahren berechnet, sondern derart, dass sich die Maskierungswerte s_t1_j,..., s_tN_j der einzelnen Zählervorrichtungen auch zeitlich zu diesem Zeitpunkt aufheben. Dies ist in den Spalten der Figur 1 dargestellt. Zum Maskieren des N-ten Einzelmesswertes c_tN_j wird deshalb ein Summenmaskierungswert Ss_tN_j durch Addieren aller i =1 bis N-1 Maskierungswerte s_ti_j der Zählervorrichtung 11.j, die für jeden der N-1 Einzelmesswerte in der Zählervorrichtung 11.j erzeugt wurde, berechnet, und der negative Summenmaskierungswert Ss_tN_j zur Maskierung des N-ten Einzelmesswertes c_tN_j verwendet. Der resultierende N-te Übertragungswert b_tN_j wird wie üblich von der Zählervorrichtung 11.j an die Aggregationsvorrichtung 12 gesandt und dort zu allen N-1 vorher empfangenen Übertragungswerten b_ti_j addiert, gemäß

$$V\_j = \sum_{i=t1}^{tN} b\_ti\_j \, mod\, 2^{32} = \sum_{i=t1}^{tN} c\_ti\_j$$

Dabei wird als letzte Messung des Zeitraums T der Zeitpunkt tN und als erste Messung des Zeitraums T der Zeitpunkt t1 gewählt.

Um auch für die letzte betrachtete Einzelmessung zum Zeitpunkt tN einen korrekten kumulierten Verbrauchswert C_tN über alle betrachteten Zählervorrichtungen 11.1,..., 11.M zu erhalten, muss ein entsprechender Summenmaskierungswert Ss_tN,1,..., Ss_tN_M für alle M Zählervorrichtungen 11.1,..., 11.M entsprechend gebildet werden. Das beschriebene Verfahren muss dabei bei allen beteiligten Zählervorrichtungen 11.1,..., 11.M zum gleichen Zeitpunkt durchgeführt werden, sodass eine entsprechende Synchronisierung notwendig ist.

Damit ist es nun möglich, den Verbrauchswert V_j einer einzelnen Zählervorrichtung 11.j über einen längeren Zeitraum T zu bestimmen, ohne datenschutzrechtlich bedenkliche Informationen über den zeitlichen Verlauf der Einzelmesswerte c_ti_j und somit des Nutzerverhaltens innerhalb des Zeitraums zu erhalten. Je nachdem wie häufig gemessen wird und wie lange der Abrechnungszeitraum T gewählt ist, muss die Anzahl N von aufeinander folgenden Messungen gewählt werden. Zum Beispiel ist bei einem bestimmten Zeitraum von einem Monat und einer Messung alle 15 Minuten eine Anzahl N von 2880 Messungen zu berücksichtigen. Bei dem gleichen bestimmten Zeitraum aber jeweils einer Messung pro Sekunde erhöht sich die Anzahl der zu berücksichtigenden Messungen auf mehr als 2,5 Millionen.

Um den Speicherbedarf sowohl in der Aggregationsvorrichtung als auch in den einzelnen Zählervorrichtungen gering halten zu können, werden in der Aggregationsvorrichtung für jede der i=2 bis N-ten Messung lediglich die bis dahin empfangenen Übertragungswerte b_ti_j durch Bildung eines Summenübertragungswertes Sb_ti_j durch Addition des Übertragungswertes b_ti_j der i-ten Messung mit einem Summenübertragungswert Sb_t(i-1)_j der vorherigen i-1-ten Messung gebildet und abgespeichert. Als Summenübertragungswert Sb_t1_j der ersten Messung wird der Übertragungswert b_ti_j der ersten Messung verwendet. In gleicher Weise wird in jeder Zählervorrichtung für jede der i=2 bis N-1-ten Messung ein i-ter Summenmaskierungswert Ss_ti_j durch Addition des Maskierungswertes s_ti_j der i-ten Messung mit einem Summenmaskierungswert Ss_t(i-1)_j der vorherigen (i-1)-ten Messung gebildet, wobei der Summenmaskierungswert Ss_t1_j der ersten Messung dem Maskierungswert s_t1_j der ersten Messung entspricht.

Durch eine Überprüfung der ermittelten Verbrauchswerte V_j jeder einzelnen Zählervorrichtung 11.1,..., 11.M kann am Ende einer Abrechnungsperiode auch eine fehlerhafte oder manipulierte Zählervorrichtung identifiziert werden, da eine solche fehlerhafte oder manipulierte Zählervorrichtung einen unsinnigen oder nicht-plausiblen Verbrauchswert V_j ergibt.

Durch einen fest vorgegebenen Zeitpunkt zur Ermittlung des Verbrauchswertes V_j kann eine regelmäßige Ablesung bzw. Bestimmung des Verbrauchswertes V_1,..., V_M einer jeden Zählervorrichtung automatisch durchgeführt werden. Somit kann beispielsweise jeden Monat der Verbrauchswert gemessen werden und somit beispielsweise Statistik über den Verbrauch abhängig von der Jahreszeit ermittelt werden. Die Anzahl N der dafür benötigten Messungen und/oder die Messzeitpunkte, t1,..., tN werde dabei so bestimmt bzw. so gewählt, dass die N-te Messung jeweils an dem fest vorgegebenen Zeitpunkt durchgeführt wird.

Andererseits kann der Zählervorrichtung und der Aggregationsvorrichtung 12 ein Zeitpunkt zur Ermittlung des Verbrauchswertes, beispielsweise durch eine Nachricht, mitgeteilt werden. Somit kann eine Zwischenablesung, beispielsweise bei Tarifwechsel oder bei Kundenwechsel, flexibel durchgeführt werden.

Durch Führen von unterschiedlichen Teilsummen, die durch mehrere verschiedene Teilverbrauchswerte mit mindestens einem unterschiedlichen ersten Zeitpunkt und/oder letztem N-ten Zeitpunkt ermittelt werden, können beispielsweise Mehrtarif-Abrechnungen mit unterschiedlichen Tarifen für unterschiedliche Zeiten einfach realisiert werden.

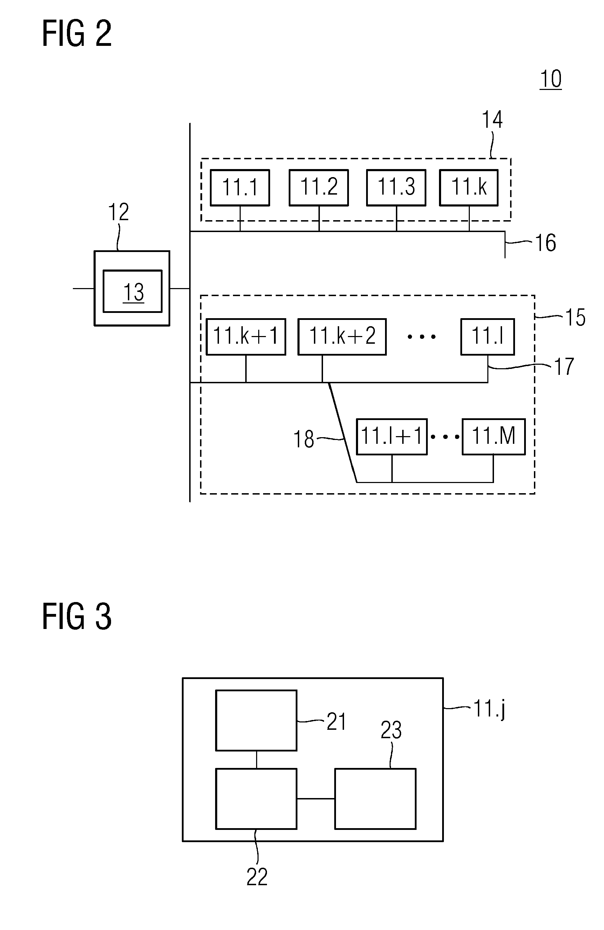

In Figur 2 ist nun ein beispielhaftes Verteilernetz 10 mit einer Vielzahl von Zählervorrichtungen 11.1,..., 11.j,..., 11.M dargestellt, die alle ihre gemessenen Einzelmesswerte c_ti_j maskiert als Übertragungswerte b_ti_j an eine verbundene Aggregationsvorrichtung 12 übermitteln. Ein solches Verteilernetz 10 ist üblicherweise in unterschiedliche Stränge 16, 17, 18 unterteilt.

Zur Ermittlung des kumulierten Verbrauchswertes V_1,...,V_M der einzelnen Zählervorrichtungen 11.1,...,11.M über einen längeren Zeitraum kann das beschriebene Verfahren entweder auf alle Zählervorrichtungen 11.1,...,11.j,...,11.M des Verteilernetzes 10 oder auch auf eine Teilmenge, beispielsweise eine Untergruppen 14, 15, von Zählervorrichtungen 11.1, ..., 11.k, 11.k+1, ..., 11.M angewendet werden und jeweils an die Aggregationsvorrichtung 12 übermittelt werden. Dabei ist darauf zu achten, dass die Anzahl der Zählervorrichtungen 11.1,..., 11.k der Untergruppe 14 sowie 11.k+1,...,11.M der zweiten Untergruppe 15 jeweils eine hinreichend große Teilanzahl von mindestens 5 bis 10 Zählervorrichtungen betragen sollte, damit die tatsächlichen Einzelmesswerte durch die Aggregation ausreichend vieler Zählervorrichtungen genügend verschleiert werden. Insbesondere für eine flexible Mehrtarif-Abrechnung können die Zählervorrichtungen mit gleichem Tarifschema eine Teilmenge bzw. Untergruppe bilden, in denen Teilsummen entsprechend der unterschiedlichen Tarifzeiten gebildet werden. Es können prinzipiell auch Einzelmesswerte von Zählervorrichtungen aus unterschiedlichen Verteilernetzen aggregiert werden.

Die in Figur 2 dargestellte Aggregationsvorrichtung umfasst eine Einzelverbrauchseinheit 13, die eine Speichereinheit sowie eine Prozessoreinheit umfasst, um aus den einzelnen empfangenen Übertragungswerten b_ti_j jeweils den Summenübertragungswert Sb_ti_j bzw. den kumulierten Verbrauchswert V_j zu berechnen und zu speichern. Alternativ kann auch jeder im vorbestimmten Zeitraum t1,..., tN empfangene Übertragungswert b_ti_j einzeln gespeichert werden.

Figur 3 zeigt eine vereinfachte Blockdarstellung einer Zählervorrichtung 11.j. Diese umfasst eine Messeinheit 21, eine Maskiereinheit 22 und eine Kumuliereinheit 23. In der Messeinheit 21 wird der Verbrauch zu einem Zeitpunkt ti bestimmt. Die Messeinheit 21 ist mit der Maskiereinheit 22 verbunden, die den Maskierungswert s_ti_j entsprechend dem angewandten Aggregationsprotokoll zusammen mit allen oder einer Untergruppe von Zählervorrichtungen bestimmt und an die Kumuliereinheit 23 weitergibt. Die Maskiereinheit 22 bildet durch Addition des Einzelmesswertes c_ti_j mit dem Maskierungswert s_ti_j den resultierenden Übertragungswert b_ti_j und sendet diesen an die Aggregationsvorrichtung 12. Die Kumuliereinheit 23 umfasst beispielsweise eine Speichereinheit sowie eine Prozessoreinheit, wobei die Prozessoreinheit den Summenmaskierungswert Ss_ti_j beispielsweise bei jeder Einzelmessung durch Addition des aktuellen Maskierungswerts s_ti_j mit dem gespeicherten Summenmaskenwert Ss_t(i-1)_j ermittelt und diesen Summenmaskierungswert Ss_ti_j speichert. Alternativ kann in der Speichereinheit jeder einzelne Maskierungswert für jede der N-1 Einzelmessungen s_ti_j speichern. Die Prozessoreinheit addiert dann lediglich für die N-te Einzelmessung alle gespeicherten s_ti_j zum Summenmaskierungswert Ss_tN_j auf.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt. So kann das Verfahren und die Zählervorrichtung nicht nur zur Ermittlung des Verbrauchs von elektrischer Energie, sondern auch zur Ermittlung des Verbrauchs von Wasser, Gas oder sonstigen Gütern eingesetzt werden.

Auch andere datenschutzrechtlich kritische Messwerte, die von mehreren Messvorrichtungen wie oben beschrieben maskiert an eine Aggregationseinheit übertragen werden, können mit dem beschriebenen Verfahren behandelt werden. Dies gilt insbesondere auch für Messwerte, bei denen beispielsweise nicht die über mehrere Messvorrichtungen oder über einen Zeitraum kumulierte Summe interessant ist, sondern deren Mittelwerte. Sind beispielsweise durch Messung der Spannung einer oder mehrerer Phasen lokal an der Zählervorrichtung Rückschlüsse auf die bezogene Leistung möglich, so kann auch die Spannung mehrerer Zählervorrichtungen maskiert an eine Aggregationsvorrichtung übertragen und dort aus der ermittelten Summe durch Division mit der Anzahl der Werte der Durchschnittswert bestimmt werden. Damit kann dann zum Einen die momentane, durchschnittlich an allen Zählervorrichtungen gemessene Spannung bestimmt werden, und erfindungsgemäß zum Zweiten noch die durchschnittliche an einer bestimmten Zählervorrichtung gemessene Spannung.

## Patentansprüche

1. Verfahren zur Ermittlung eines zeitlich kumulierten Verbrauchswertes (V_j) aus Einzelmesswerten (c_ti_j), die von einer Zählervorrichtung (11.j) in einer Anzahl von N aufeinanderfolgenden Messungen über einen bestimmten Zeitraum (T) gemessen werden, mit den Verfahrensschritten:

   - Maskieren eines i-ten Einzelmesswerts (c_ti_j), der von der Zählervorrichtung (11.j) zu einem i-ten Zeitpunkt (ti) gemessen wird durch Addieren mit einem Maskierungswert (s_ti_j) zu einem Übertragungswert (b_ti_j) und Senden des Übertragungswertes (b_ti_j) von der Zählervorrichtung (11.j) zu einer Aggregationsvorrichtung (12), für alle i = 1 bis N-1 Einzelmesswerte (c_ti_j),
   **gekennzeichnet durch** die weiteren Verfahrensschritte
   - Addieren aller N-1 Maskierungswerte (s_ti_j) der Zählervorrichtung (11.j), die für jeden der (N-1)-ten Einzelmesswerte (c_ti_j) erzeugt wurden, zu einem Summenmaskierungswert (Ss_tN_j) in der Zählervorrichtung (11.j),
   - Maskieren eines N-ten Einzelmesswertes (c_tN_j), der von der Zählervorrichtung (11.j) zum N-ten Zeitpunkt gemessen wird mit dem negativen Summenmaskierungswert (Ss_tN_j) zu einem Übertragungswert(b_tN_j), und
   - Senden des N-ten Übertragungswerts (b_tN_j) von der Zählervorrichtung (11.j) an die Aggregationsvorrichtung (12) und
   - Addieren aller N empfangenen Übertragungswerte (b_ti_j) der Zählervorrichtung (11.j) zu einem zeitlich kumulierten Verbrauchswert (V_j) in der Aggregationsvorrichtung (12).

2. Verfahren nach Anspruch 1, wobei die Zählervorrichtung (11.j) für jede der i = 2 bis (N-1)-ten Messung einen i-ten Summenmaskierungswert (Ss_ti_j) durch Addition des Maskierungswerts (s_ti_j) der i-ten Messung mit einem Summenmaskierungswert (Ss_t(i-1)_j) der vorherigen (i-1)-ten Messung bildet, wobei der Summenmaskierungswert der ersten Messung (Ss_t1_j) dem Maskierungswert (s_t1_j) der ersten Messung entspricht und lediglich den i-ten Summenmaskierungswert (Ss_ti_j) speichert.

3. Verfahren nach Anspruch 1 oder 2, wobei die Aggregationsvorrichtung (12) für jede der i = 2 bis N-ten Messung einer Zählervorrichtung (11.j) einen i-ten Summenübertragungswert (Sb_ti_j) durch Addition des Übertragungswertes (b_ti_j) der i-ten Messung mit einem Summenübertragungswert (Sb_t(i-1)_j) der vorherigen (i-1)-ten Messung bildet, wobei der Summenübertragungswert (Sb_t1_j) der ersten Messung dem Übertragungswert (b_t1_j) der ersten Messung entspricht und lediglich den i-ten Summenübertragungswert speichert.

4. Verfahren nach einem der Ansprüche 1 bis 3, wobei der Zeitpunkt zur Ermittlung des Verbrauchswerts V_j fest vorgegeben ist und somit die Anzahl N der Messungen und/oder die Messzeitpunkte (t1, ..., tN) so gewählt wird bzw. werden, dass die N-te Messung jeweils zu der vorgegebenen Zeit durchgeführt wird.

5. Verfahren nach einem der Ansprüche 1 bis 4, wobei der Zeitpunkt zur Ermittlung des Verbrauchswerts V_j der Zählervorrichtung (11.j) und der Aggregationsvorrichtung (12) mitgeteilt wird.

6. Verfahren nach einem der Ansprüche 1 bis 5, wobei mehrere verschiedene Teil-Verbrauchswerte ($V\_a\_j$, $V\_b\_j$) mit mindestens einem unterschiedlichen ersten Zeitpunkt (t1) und/oder letzten, N-ten Zeitpunkt (tN) ermittelt werden.

7. Verfahren nach einem der Ansprüche 1 bis 6, wobei lediglich eine Teilmenge der Zählervorrichtungen (11.1,..., 11.k) jeweils zur gleichen Zeit ($ti\_1$,..., $ti\_k$) eine Messung eines Einzelmesswertes ($c\_ti\_1$,..., $c\_ti\_k$) durchführen.

8. Zählervorrichtung zur Ermittlung eines kumulierten Verbrauchswertes ($V\_j$) über einen bestimmten Zeitraum (T), umfassend eine Messeinheit (21), eine Maskiereinheit (22) und eine Kumuliereinheit (23), wobei die Messeinheit (21) derart ausgebildet ist um in einer Anzahl von N aufeinanderfolgenden Messungen eine Anzahl von N Einzelmesswerten ($c\_ti\_j$) zu ermitteln,
die Maskiereinheit (22)derart ausgebildet ist einen i-ten Einzelmesswert ($c\_ti\_j$), der zu einem i-ten Zeitpunkt (ti) gemessen wird, durch Addieren mit einem Maskierungswert ($s\_ti\_j$) zu einem Übertragungswert ($b\_ti\_j$) zu maskieren und den Übertragungswert ($b\_ti\_j$) zum i-ten Zeitpunkt (ti) zu einer Aggregationsvorrichtung (12) zu senden, für alle i = 1 bis N-1 Einzelmesswerte($c\_ti\_j$),
die Kumuliereinheit (23) derart ausgebildet ist, alle N-1 Maskierungswerte ($s\_ti\_j$), die für jeden der N-1 Einzelmesswerte ($c\_ti\_j$) erzeugt wurden, zu einem Summenmaskierungswert ($Ss\_t(N-1)\_j$) zu addieren, den N-ten Einzelmesswert ($c\_tN\_j$), der zum N-ten Zeitpunkt gemessen ist, mit dem negativen Summenmaskierungswert ($Ss\_tN\_j$) zu einem Übertragungswert ($b\_tN\_j$) zu maskieren, und den N-ten Übertragungswert ($b\_tN\_j$) an die Aggregationsvorrichtung (12) zu senden.

9. Zählervorrichtung nach Anspruch 8, wobei die Kumuliereinheit (23) derart ausgebildet ist, für jede der i = 2 bis (N-1)-ten Messung einen i-ten Summenmaskierungswert ($Ss\_ti\_j$) durch Addition des Maskierungswert ($s\_ti\_j$) der i-ten Messung mit einem Summenmaskierungswert ($Ss\_t(i-1)\_j$) der vorherigen (i-1)-ten Messung zu bilden, wobei der Summenmaskierungswert ($Ss\_t1\_j$) der ersten Messung dem Maskierungswert ($s\_t1\_j$) der ersten Messung entspricht und lediglich den i-ten Summenmaskierungswert zu speichern.

10. Zählervorrichtung nach Anspruch 8 oder 9, der derart ausgebildet ist, das Verfahren gemäß Anspruch 1 bis 7 auszuführen.

11. Aggregationsvorrichtung zur Ermittlung eines kumulierten Verbrauchswertes ($V\_j$) über einen bestimmten Zeitraum (T), umfassend eine Einzelverbrauchsberechnungseinheit (13), die derart ausgebildet ist, alle N empfangenen Übertragungswerte ($b\_ti\_j$) einer Zählervorrichtung (11.j) zu einem Verbrauchswert ($V\_j$) zu addieren.

12. Aggregationsvorrichtung nach Anspruch 11, wobei die Einzelverbrauchseinheit (13) derart ausgebildet ist, für jede der i = 2 bis N-ten Messung einen i-ten Summenübertragungswert ($Sb\_ti\_j$) durch Addition des Übertragungswertes ($b\_ti\_j$) der i-ten Messung mit einem Summenübertragungswert ($Sb\_t(i-1)\_j$) der vorherigen (i-1)-ten Messung zu bilden, wobei der Summenübertragungswert ($Sb\_t1\_j$) der ersten Messung dem Übertragungswert ($b\_t1\_j$) der ersten Messung entspricht und lediglich den i-ten Summenübertragungswert ($Sb\_ti\_j$) zu speichern.

13. Aggregationsvorrichtung nach Anspruch 11 oder 12, der derart ausgebildet ist das Verfahren gemäß Anspruch 1 bis 7 auszuführen.

14. Computerprogrammprodukt mit Programmbefehlen zur Durchführung des Verfahrens nach Ansprüchen 1-7.

15. Datenträger, der das Computerprogrammprodukt nach Anspruch 14 speichert.

# FIG 1

EP 2 871 797 A1

## FIG 2

## FIG 3

Europäisches Patentamt
European Patent Office
Office européen des brevets

**EUROPÄISCHER RECHERCHENBERICHT**

Nummer der Anmeldung

EP 14 18 2439

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | KLAUS KURSAWE ET AL: "Privacy-Friendly Aggregation for the Smart-Grid", 27. Juli 2011 (2011-07-27), PRIVACY ENHANCING TECHNOLOGIES : 11TH INTERNATIONAL SYMPOSIUM, PETS 2011, WATERLOO, CANADA, JULY 27-29, 2011 ; PROCEEDINGS; [LECTURE NOTES IN COMPUTER SCIENCE , ISSN 0302-9743 ; ZDB-ID: 1219091 ; 6794], SPRINGER, BERLIN; HEIDELBERG, PAGE(S) 175 - 191, XP047025539, ISBN: 978-3-642-22262-7 * das ganze Dokument * ----- | 1-15 | INV. H04L9/00 G01D4/00 |
| X | ERKIN Z ET AL: "Privacy-preserving data aggregation in smart metering systems: an overview", IEEE SIGNAL PROCESSING MAGAZINE, IEEE SERVICE CENTER, PISCATAWAY, NJ, US, Bd. 30, Nr. 2, 1. März 2013 (2013-03-01), Seiten 75-86, XP011505539, ISSN: 1053-5888, DOI: 10.1109/MSP.2012.2228343 * Abbildung 2 * * Kapitel: "Involved Parties in a Private Smart Metering Scenario" * * Kapitel: "Functions of Interest: Private Utility" - "Discussion"; Seite 78 - Seite 83 * ----- -/-- | 1-15 | |

RECHERCHIERTE SACHGEBIETE (IPC)

H04L
G01D

Der vorliegende Recherchenbericht wurde für alle Patentansprüche erstellt

| Recherchenort | Abschlußdatum der Recherche | Prüfer |
|---|---|---|
| Berlin | 13. März 2015 | Höller, Helmut |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................................
& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

Nummer der Anmeldung

EP 14 18 2439

| | EINSCHLÄGIGE DOKUMENTE | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| A | ZEKERIYA ERKIN ET AL: "Private Computation of Spatial and Temporal Power Consumption with Smart Meters", 26. Juni 2012 (2012-06-26), APPLIED CRYPTOGRAPHY AND NETWORK SECURITY, SPRINGER BERLIN HEIDELBERG, BERLIN, HEIDELBERG, PAGE(S) 561 - 577, XP047007128, ISBN: 978-3-642-31283-0 * Abbildung 2 * * Kapitel 3 "Preliminaries"-6 "Computing Spatio-temporal Consumption" * ----- | 1-15 | |
| A | ANN CAVOUKIAN ET AL: "Implementing Privacy by Design: The smart meter case", SMART GRID ENGINEERING (SGE), 2012 IEEE INTERNATIONAL CONFERENCE ON, IEEE, 27. August 2012 (2012-08-27), Seiten 1-8, XP032331812, DOI: 10.1109/SGE.2012.6463977 ISBN: 978-1-4673-4457-9 * Kapitel "VI. Aggregation Protocols for Smart Meter Data Minimization" * ----- | 1-15 | |
| A | GERGELY ÁCS ET AL: "I Have a DREAM] (DiffeRentially privatE smArt Metering)", 18. Mai 2011 (2011-05-18), INFORMATION HIDING, SPRINGER BERLIN HEIDELBERG, BERLIN, HEIDELBERG, PAGE(S) 118 - 132, XP019164139, ISBN: 978-3-642-24177-2 * Zusammenfassung * * Kapitel: 4 "Secure Aggregation without Aggregator: An Overview"-5 "Protocol Description" * ----- -/-- | 1-15 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| Berlin | 13. März 2015 | Höller, Helmut |

EPO FORM 1503 03.82 (P04C03)

Europäisches
Patentamt
European
Patent Office
Office européen
des brevets

## EUROPÄISCHER RECHERCHENBERICHT

Nummer der Anmeldung

EP 14 18 2439

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | WO 2012/103896 A1 (NEC EUROPE LTD [DE]; UNVERSIDAD DE MURCIA [ES]; GOMEZ MARMOL FELIX [ES] 9. August 2012 (2012-08-09) <br> * Abbildungen 2, 3 * <br> * Seite 2, Absatz 4 * <br> * Seite 6, Absatz 2 * <br> * Seite 11, Absatz 3 * <br> ----- | 1-15 | |
| T | Anonymous: "Getting N random numbers that the sum is M", <br> , <br> 14. April 2010 (2010-04-14), XP055176321, <br> Gefunden im Internet: <br> URL:http://stackoverflow.com/questions/2640053/getting-n-random-numbers-that-the-sum-is-m <br> [gefunden am 2015-03-13] <br> * das ganze Dokument * <br> ----- | 1-15 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| Berlin | 13. März 2015 | Höller, Helmut |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes
   Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 14 18 2439

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-03-2015

| Im Recherchenbericht angeführtes Patentdokument | Datum der Veröffentlichung | Mitglied(er) der Patentfamilie | | Datum der Veröffentlichung |
|---|---|---|---|---|
| WO 2012103896 A1 | 09-08-2012 | EP | 2540027 A1 | 02-01-2013 |
| | | ES | 2448806 T3 | 17-03-2014 |
| | | JP | 5500666 B2 | 21-05-2014 |
| | | JP | 2013543357 A | 28-11-2013 |
| | | US | 2013124850 A1 | 16-05-2013 |
| | | WO | 2012103896 A1 | 09-08-2012 |

EPO FORM P0461

Für nähere Einzelheiten zu diesem Anhang : siehe Amtsblatt des Europäischen Patentamts, Nr.12/82

**EP 2 871 797 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Privacy-Friendly Aggregation for the Smart-Grid. **KLAUS KURSAWE ; GEORGE DANEZIS ; MARKULF KOHLWEISS.** Privacy Enhancing Technologies, 11th International Symposium, PETS 2011. Springer Verlag, 27. Juli 2011, 175-191